# EUROPEAN PATENT APPLICATION

(11) **EP 2 284 921 A2**
(43) Date of publication of application: **16.02.2011**
(21) Application number: 09014749.7
(22) Date of filing: 26.11.2009
(51) Int. Cl.: H01L 51/50, H01L 51/52

(54) **Organic electroluminescence element**

(30) Priority: 05.08.2009 JP 2009182521
(71) Applicant: Yamagata Promotional Organization for Industrial Technology, Yamagata-shi Yamagata 990-2473 (JP)
(72) Inventor: Oda, Atsushi, Yamagata 990-2473 (JP); Tanaka, Junichi, Yamagata 990-2473 (JP); Kawai, Takashi, Yamagata 990-2473 (JP)
(74) Representative: HOFFMANN EITLE

(57) **Abstract**

The present invention provides an organic EL element having a multi-photon structure, in which optical absorption in the visible region caused by a charge-transfer complex in a conventional intermediate layer structure is inhibited, and the resistance of this intermediate layer to a counter career is improved, thus allowing high efficiency and a long operation life of the element.

The element is arranged to be formed on a substrate 1 and have a multi-photon structure in which a plurality of light emitting units 4 including at least one light emitting layer are stacked via an intermediate layer 5 between an anode layer 2 and a cathode layer 3 which is a counter electrode, the above-mentioned intermediate layer 5 is formed by mixing or stacking an electron accepting material or an electron donating material and an organic compound, so as to avoid formation of a charge-transfer complex.

## Description

### BACKGROUND OF THE INVENTION

### Field of the Invention

The present invention relates to an organic electroluminescence (EL) element which can be used suitably for illumination and has optical permeability.

### Description of the Related Art

Since the organic EL element is a self-emitting type element which includes an organic compound as a light emitting material and allows luminescence at a high speed, it is suitable for displaying a video image, and it has features that allow an element structure to be simple and a display panel to be thin. Having such outstanding features, the organic EL element is spreading in everyday life as a mobile phone display or a vehicle-mounted display.

Further, in recent years, it has attracted attention as next-generation lighting, taking advantage of the features of thin plane luminescence as described above.

The above-mentioned organic EL element is required to attain high efficiency and a long operation life in order to improve and spread its practical use, and a multi-photon structure is proposed as one means.

The organic EL element with a conventional multi-photon structure has a structure in which light emitting units including at least one light emitting layer are connected in series via an intermediate layer referred to as a charge generating layer and a charge-transfer complex is formed in the above-mentioned intermediate layer, to thereby function as a so-called multi-photon element.

For example, Japanese Patent No. 3933591 says that it is essential to form a charge-transfer complex since it has a mechanism where positive and negative charges polarized at a charge generating layer are easily separated by application of an external electric field, and discloses an arrangement of (electron transport material + electron donating material / arylamine compound + electron accepting substance) as the above-mentioned intermediate layer which forms the charge-transfer complex.

Further, Japanese Patent Application Publication No. 2004-39617 discloses that an adjacent pn hetero-junction may allow similar charge generation as with inorganic semiconductors, such as a tunnel diode and Type III hetero-junction. But, it discloses that as an acceptor used for a p-type doped organic layer it is necessary to form a charge-transfer complex between a host and the dopant. Further, Japanese Patent Application Publication No. 2003-182774 describes an n-type doped organic layer.

Furthermore, Japanese Patent Application Publication No. 2003-264085 discloses that a conductive layer is used as the intermediate layer and a mixture of a donor and an acceptor as an example, but this also requires formation of the charge-transfer complex.

Thus, in the conventional multi-photon element (also referred to as stack type and tandem type), it has been essential to form the charge-transfer complex in order to generate charge in the intermediate layer.

However, in the above-mentioned intermediate layer, the charge-transfer complex formed between "arylamine compound + electron accepting material etc." generally has optical absorption in a visible region from blue to green, which is not preferred in terms of improvement in luminous efficiency, or permeability of a device itself.

Further, it is known that the arylamine compound provides a hole transport property while it is very susceptible to electron which is a counter career.

Thus, the intermediate layer structure as described above has a problem in improving characteristics of the device, and there is a need for improving the intermediate layer structure in terms of high efficiency and a longer operation life.

### SUMMARY OF THE INVENTION

The present invention arises in order to solve the above-mentioned technical problems, and aims at providing an organic EL element with a multi-photon structure, in which optical absorption in the visible region caused by a charge-transfer complex in a conventional intermediate layer structure is inhibited, and resistance of this intermediate layer to a counter career is improved, thus allowing high efficiency and a long operation life of the element.

The organic EL element in accordance with the present invention is formed on a substrate and has a multi-photon structure in which a plurality of light emitting units including at least one light emitting layer are stacked via an intermediate layer between an anode layer and a cathode layer which is a counter electrode, wherein the above-mentioned intermediate layer is formed by mixing or stacking an electron accepting material or an electron donating material and an organic compound, so as to avoid formation of a charge-transfer complex.

According to such an element structure, it is possible to inhibit the optical absorption in the visible region caused by the charge-transfer complex generated in the conventional intermediate layer structure, and the resistance of this intermediate layer to the counter career can be improved.

In the above-mentioned organic EL element, it is preferable that the above-mentioned intermediate layer is formed by mixing or stacking the electron accepting material and the organic compound, and its optical absorption coefficient in a 400-800 nm wavelength band is equal to or less than an optical absorption coefficient of the above-mentioned organic compound simple substance.

Further, the organic EL element of another embodiment in accordance with the present invention is an organic EL element formed on a substrate and having a multi-photon structure in which a plurality of light emitting units including at least one light emitting layer are stacked via an intermediate layer between an anode layer and a cathode layer which is a counter electrode, wherein the above-mentioned intermediate layer is formed of a layer in which an electron accepting material and an organic compound are mixed or stacked and a layer in which an electron donating material and the same organic compound as the above-mentioned organic compound are mixed or stacked, to avoid formation of a charge-transfer complex.

Thus, it is possible to constitute the organic EL element by forming the layer in which the same organic compound is mixed with or stacked on each of the electron accepting material and the electron donating material as the intermediate layer, to thereby provide the effect similar to the above without forming the charge-transfer complex.

It is preferable that the above-mentioned organic compound to be mixed with or stacked on the above-mentioned electron accepting material is a non-arylamine compound which does not contain, in its molecular structure, nitrogen atom having an electron donating property.

Thus, it is arranged that a compound which contains nitrogen atom having an electron donating property, such as a conventional arylamine compound, is not applied to the intermediate layer, to thereby allow a long operation life and high efficiency of the multi-photon element.

It is preferable that the above-mentioned non-arylamine compound is a styryl compound or a polyarylene compound.

Further, it is preferable that the above-mentioned electron accepting material is a metal oxide, and it is particularly preferable that it is any of a molybdenum oxide, a vanadium oxide, or a tungsten oxide.

According to the present invention, in the organic EL element with the multi-photon structure, the optical absorption in the visible region caused by the charge-transfer complex in the conventional intermediate layer structure can be inhibited, and resistance of this intermediate layer to the counter career is improved, thus allowing high efficiency and the long operation life of the element.

Therefore, as for the organic EL element in accordance with the present invention, it is possible to utilize the characteristics excellent in high color rendering properties as a plane light-emitting member, not only for use in a conventional display but also for use in a light source, such as illumination.

### BRIEF DESCRIPTION OF THE DRAWINGS

FIG. 1 is a sectional view schematically showing a layer structure of an organic EL element in accordance with the present invention.
FIG. 2 is a graph showing a relationship between current efficiency and current density of each organic EL element in Experiment 1.
FIG. 3 shows UV absorption spectra of a simple substance film of spiro-DPVBi and a co-deposited film.
FIG. 4 shows UV absorption spectra of a simple substance film of spiro-6p and a co-deposited film.
FIG. 5 shows UV absorption spectra of a simple substance film of α-NPD and a co-deposited film.
FIG. 6 shows an UV absorption spectrum of a molybdenum trioxide simple substance film.
FIG. 7 is a graph showing a relationship between current efficiency and current density of each organic EL element in Experiment 3.
FIG. 8 is a graph showing a life characteristic of each organic EL element in Example 5 and Comparative Example 5.
FIG. 9 is a graph showing a relationship between current efficiency and current density of each organic EL element in Experiment 4.
FIG. 10 is a graph showing a relationship between current efficiency and current density of each organic EL element in Experiment 5.
FIG. 11 is UV absorption spectrum of a stacked layer film of "co-deposited film of spiro-DPVBi and Liq / Al / co-deposited film of spiro-DPVBi and vanadium pentoxide".
FIG. 12 is an UV absorption spectrum of a vanadium-pentoxide simple substance film.

### DESCRIPTION OF THE PREFFERED EMBODIMENTS

Hereafter, the present invention will be described in detail with reference to the drawings.

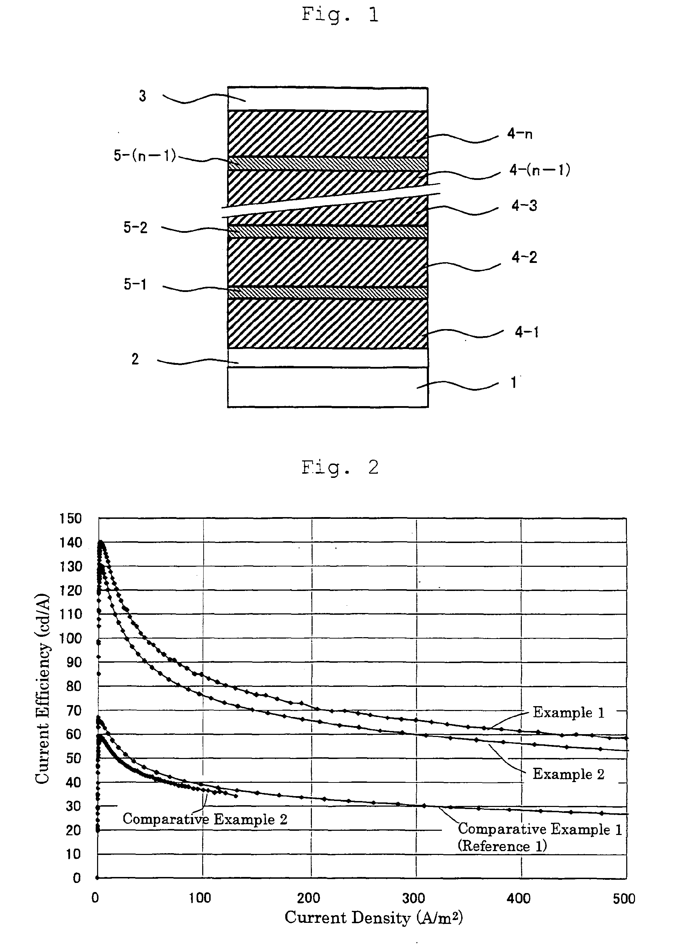

FIG. 1 illustrates an outline of a layer structure of an organic EL element in accordance with the present invention.

The organic EL element as shown in FIG. 1 is formed on a substrate 1, and is an organic EL element having a multi-photon structure in which n light emitting units 4-1, 4-2, 4-3, ... , 4-n including at least one light emitting layer are stacked via intermediate layers 5-1, 5-2,..., 5-(n-1) between an anode layer 2 and a cathode layer 3 which is a counter electrode. Further, it is **characterized in that** the above-mentioned intermediate layers 5-1, 5-2, ... , 5- (n-1) are formed by mixing or stacking an electron accepting material or an electron donating material and an organic compound, so as to avoid formation of a charge-transfer complex.

Thus, it differs from a conventional intermediate layer in that the charge-transfer complex is not formed in the intermediate layer between the plurality of light emitting units of the multi-photon structure.

Since the intermediate layer is arranged to have such a structure, it is possible to inhibit optical absorption loss in the visible region caused by the charge-transfer complex, and it is also possible to positively employ a material excellent in resistance to a counter career.

As will be shown in the following Examples, it is not essential that the above-mentioned intermediate layer contains an electron donating material, but it may be constructed by a mixture or a laminate of the electron accepting material and the organic compound, and preferably be formed by mixing or stacking the electron accepting material and the organic compound.

In order to improve efficiency of the element, it is preferable that this intermediate layer has an optical absorption coefficient, in a 400-800 nm wavelength band, i.e., the visible region, which is equal to or less than an optical absorption coefficient of the above-mentioned organic compound simple substance.

Further, the intermediate layer may be formed of a layer in which the electron accepting material and the organic compound are mixed or stacked and a layer in which the electron donating material and the same organic compound as the above-mentioned organic compound are mixed or stacked. In this case, it is preferable to use the same organic compounds which are respectively mixed with or stacked on the electron accepting material and the electron donating material.

Thus, it is possible to avoid the charge-transfer complex from being formed in the intermediate layer.

In the above-mentioned intermediate layer, it is preferable that the organic compound to be mixed with or stacked on the electron accepting material is a single compound. It is particularly preferable to use a non-arylamine compound that does not contain, in its molecular structure, nitrogen atom having an electron donating property.

Thus, the intermediate layer is formed without using the compounds containing nitrogen atom having the electron donating property, such as the arylamine compound conventionally and generally used as a compound which constitutes the charge generating layer, whereby a function as a multi-photon element is demonstrated without forming the charge-transfer complex and it is possible to provide a longer operation life as compared with the conventional element which uses the arylamine compound for the intermediate layer.

As examples of the organic compound in the above-mentioned intermediate layer, there may be particularly mentioned a styryl compound and a polyarylene compound. For example, it is preferable to use a compound (spiro-DPVBi) as shown in the following (Chemical Formula 1) which is a styryl compound.

As such, the non-arylamine compound can suitably be employed which is a bipolar material tolerant to both a positive hole and an electron.

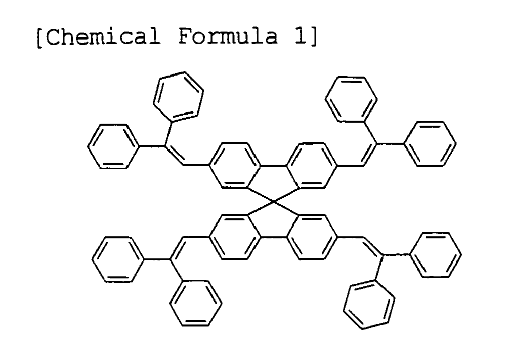

Further, it is preferable that the above-mentioned electron accepting material is a metal oxide. In particular, it is suitably use a molybdenum oxide, a vanadium oxide, a tungsten oxide, etc. It is preferable to co-deposit or stack these electron accepting materials and non-arylamine compounds, such as spiro-DPVBi, and to form the intermediate layer.

Hereafter, a mechanism of the charge generating layer by means of the intermediate layer will be described.

It is known that the charge-transfer complex formed of the arylamine compound and conventional electron accepting material in the intermediate layer of the conventional multi-photon element shows an absorption peak at a wavelength band of approximately 450-500 nm.

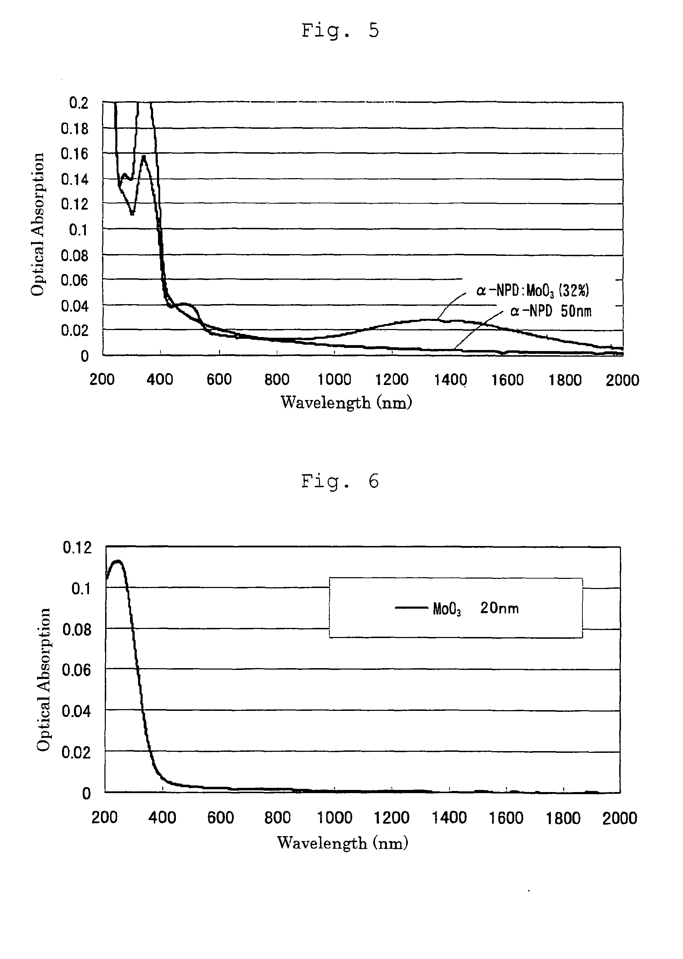

For example, as will be shown in the following Comparative Example 3, in the conventional charge generating layer in which α-NPD is doped with molybdenum trioxide (MoO₃) absorption occurs near 500 nm and near 1300 nm (see FIG. 5). By way of molecular orbital calculation, it is possible to confirm that this absorption is caused by the charge-transfer complex formed of MoO₃ and α-NPD.

Some configurations having initial values that are molecular coordinates where MoO₃ is configured near α-NPD are subjected to structure optimization by B3LYP/6-31++G (d, p) using a mathematical software package Gaussian03. Then, energy calculation is carried out by B3LYP/6-311++G(d, p) in the case where charges are 0, +1, and -1. Further, using a TD method, absorption wavelengths are calculated by B3LYP/6-31++G (d, p). As a result, the α-NPD molecule in which MoO₃ is configured acts as one molecule. At this time, very strong absorptions are confirmed such that oscillator strengths are respectively 0.029 and 0.061 at wavelengths of 529 nm and 1174 nm, an oscillator strength is 0.405 at a wavelength of 1369 nm, and a plurality of weak absorptions are observed at wavelengths of 550 nm - 600 nm.

These absorption peaks are in agreement with absorptions actually observed as shown in FIG. 5.

Further, if electron affinity and ionization potential at a molecular level are found by way of the above-mentioned energy calculation, then they are respectively 3.53 eV and 4.70 eV. In view of polarization energy 0.6 eV of α-NPD to be a matrix, they are substantially in agreement with the electron affinity of 4.13 eV and the ionization potential of 4.10 eV of α-NPD where MoO₃ is configured in a doped layer.

Therefore, it is possible to confirm that this molecule is a charge-transfer complex which causes charge separation, i.e., charge generation, spontaneously (the smaller a difference between the electron affinity and ionization potential, the larger the charge-transfer in a molecule).

Further, in view of molecular orbital distribution of HOMO or LUMO of this molecule, it is possible to confirm that the charge is considerably deviated. From this point, it is also considered that the charge-transfer complex is formed.

Generally, as with arylamine represented by α-NPD, a molecule which includes nitrogen atom and whose isolated electron pair interact with π electron tends to form the charge-transfer complex, since its configuration having an electron-attractive group, such as a metal oxide, causes electron deficiency easily.

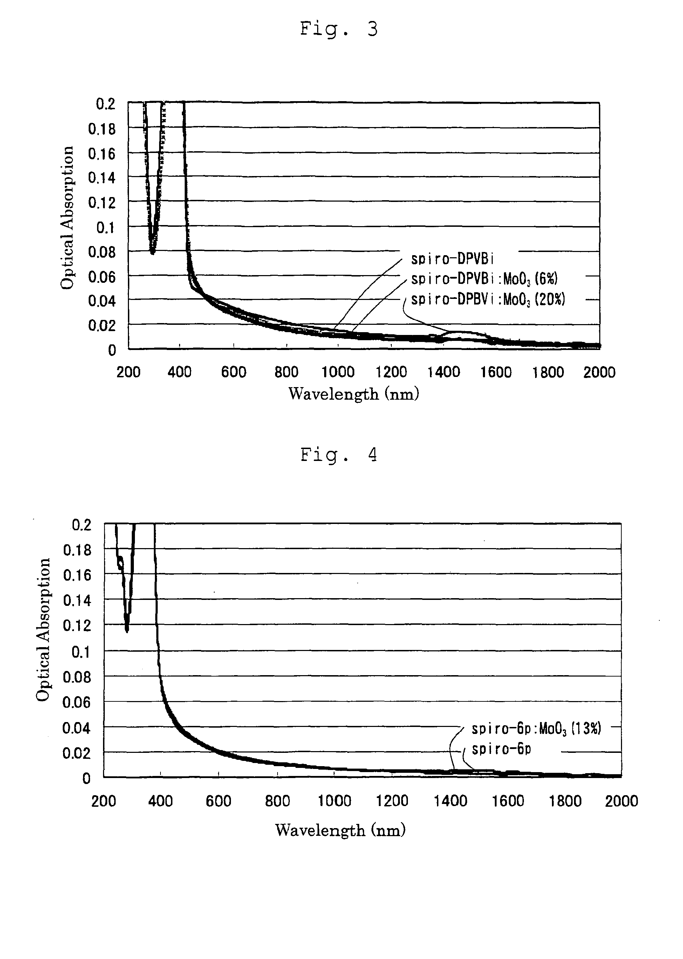

On the other hand, for example, an absorption peak is not observed near 500 nm in the charge generating layer in which spiro-DPVBi as shown in the following Examples 3 and 4 or polyarylene type spiro-6p as shown in the following (Chemical Formula 2) is doped with molybdenum trioxide (MoO₃), and the charge-transfer complex is not formed (see FIGS. 3 and 4) .

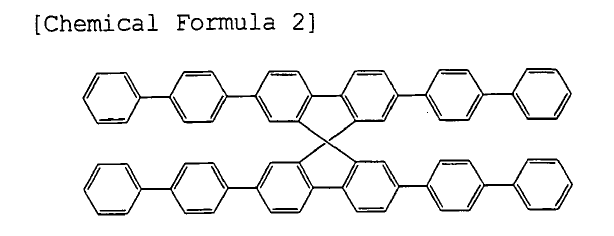

In the case of calculating spiro-6p as with the above description, strong absorption exists only on a short wavelength side, shorter than 480 nm, with respect to spiro-6p in which MoO₃ is configured and a strong charge distribution bias is not confirmed, either.

Further, the electron affinity and ionization potential at a molecular level are 2.04 eV and 6.41 eV, respectively. Although the electron affinity differs compared with the electron affinity of 1.04 eV and the ionization potential of 6.46 eV of a spiro-6p simple substance, there is not so large a difference in energy level as compared with α-NPD, and it is possible to confirm that the charge-transfer complex is not formed.

Therefore, the reason why the intermediate layer using spiro-6p operates as the charge generating layer is that the above-mentioned electron affinity has fallen to 2.04 eV. It is assumed that this is because spiro-6p in which MoO₃ is configured acts as a weak acceptor with respect to the spiro-6p simple substance, spiro-6p forms a p-type doped layer, and a level of the electron affinity of spiro-6p in which MoO₃ is configured helps electrons to be injected into an adjoining electronic transport layer.

As examples of the organic compound in which such a phenomenon occurs, i.e., the metal oxide is configured, acts as the weak acceptor and an intermediate level of electron injection of the original organic compound, there may also be mentioned other polyarylene compounds and styryl compounds. It is assumed that it may be caused by formation of a suitable level since the metal oxide is configured in a π conjugated system.

A structure of the substrate of the organic EL element in accordance with the present invention, the anode layer, the light emitting unit, and the cathode layer, i.e., the layer structure of these other than the intermediate layer may have the same structure as that of the conventional and usual multi-photon element.

Hereafter, an example of a particular embodiment of each layer will be described.

Of the structural elements of the organic EL element in accordance with the present invention, the substrate serves as a support member for the organic EL element and as a luminescence side, thus its optical transmissivity is preferably 80% or more, and more preferably 90% or more.

In general, the above-mentioned substrate employs glass substrates made of, such as for example, optical glass (BK7, BaK1, F2, etc.), silica glass, non alkali glass, borosilicate glass, aluminosilicate glass, polymer substrates made of, such as for example, acrylic resins (PMMA, etc.), polycarbonate, polyether sulphonate, polystyrene, polyolefin, an epoxy resin, polyester (such as polyethylene terephthalate), etc.

Although the above-mentioned substrate having a thickness of approximately 0.1-10 mm is usually used, it is preferable that the thickness is 0.3-5 mm in view of mechanical strength, weight, etc. More preferably it is 0.5-2 mm.

The above-mentioned anode layer is formed of an electrode material having a high work function (4.0 eV or more), as a transparent electrode on the above-mentioned substrate.

Such a transparent electrode can also be formed of thin films made of metals (gold, silver, nickel, palladium, platinum, etc.). However, metal oxides (such as indium tin oxide (ITO), indium zinc oxide, zinc oxide, etc.) are used generally. In particular, ITO is suitably used in terms of transparency, conductivity, etc.

In order to secure transparency and conductivity, a film thickness of the transparent electrode is preferably 80-400 nm. More preferably, it is 100-200 nm.

It is preferable that the anode layer is usually formed by a CVD process, a sputtering process, a vacuum deposition process, etc., and formed as a transparent conductive thin film.

The cathode layer which is on the opposite side of the above-mentioned anode layer is usually constituted by metals and alloys having a low (4 eV or less) work function. As examples, there may be mentioned aluminum, an aluminum-lithium alloy, a magnesium silver alloy, etc.

It is preferable that a film thickness of the above-mentioned cathode layer is 10-500 nm. More preferably, it is 50-200 nm.

The above-mentioned cathode layer may also be formed by conventionally used methods, such as a CVD method, a sputtering method, a vacuum deposition method, etc.

Further, one unit of the above-mentioned light emitting units may only have at least one light emitting layer, and may be of a single layer or multiple layers. Still further, it may have a layer structure of a known organic EL element. As particular examples of the layer structure of the above-mentioned light emitting unit 3, there may be mentioned structures of "light emitting layer only", "hole transport layer / light emitting layer", "light emitting layer / electron transport layer", "hole transport layer / light emitting layer / electron transport layer", etc.

Furthermore, it may employ the known layer structure including a hole injection layer, a hole transport light emitting layer, a hole inhibition layer, an electron injection layer, an electron transport light emitting layer, etc.

Since the organic EL element in accordance with the present invention is the multi-photon element, a plurality of the above-mentioned light emitting units are stacked via the intermediate layers. The plurality of light emitting units to be stacked may have either the same structure or different structures.

The material that constitutes each layer of the above-mentioned light emitting unit is not particularly limited and a known one can be used. Further, it may be either a low molecular weight material or a high molecular weight material.

The formation of each of these layers can be performed by way of dry processes, such as a vacuum deposition process, a sputtering process, etc., and wet processes, such as an ink-jet process, a casting process, a dip coat process, a bar coat process, a blade coat process, a roll coat process, a photogravure coat process, a flexographic printing process, a spray coat process, etc. Preferably, the film formation is carried out by vacuum deposition.

Further, although a film thickness of each of the above-mentioned layers is suitably determined depending on its conditions in view of adaptability between the respective layers, the overall layer thickness to be required, etc., it is usually preferable to be within a range from 5 nm to 5 µm.

Hereafter, the present invention will be described more particularly with reference to Examples, but the present invention is not limited to the following Examples.

### [Experiment 1] Evaluation by Green Phosphorescence Element

### (Example 1)

First, a glass substrate having formed thereon a patterned transparent electroconductive film (ITO) with a film thickness of 110 nm was subjected to washing treatments in the order of ultrasonic cleaning by pure water and a surfactant, washing with flowing pure water, ultrasonic cleaning by a 1:1 mixed solution of pure water and isopropyl alcohol, and boiling washing by isopropyl alcohol. This substrate was slowly pulled up from the boiling isopropyl alcohol, and dried in isopropyl alcohol vapor, and, finally ultraviolet ozone cleaning was performed.

This substrate was placed in a vacuum chamber which was evacuated to 1×10⁻⁶ Torr. In this vacuum chamber, each molybdenum boat filled up with a vapor deposition material and a vapor deposition mask for forming a film in a predetermined pattern were placed, the above-mentioned boat was electrically heated, and the vapor deposition material was evaporated to thereby form a hole transport layer, a first light emitting unit, the intermediate layer, and a second light emitting unit one by one, to have a layer structure as shown by Example 1 in the following Table 1, where BTPS used for the first and second light emitting units was a sulfone compound and DPB was a phenanthroline derivative.

As for the intermediate layer, spiro-DPVBi which is a non-arylamine compound, and the molybdenum trioxide which is an electron accepting material were co-deposited, on which a compound (spiro-TAD) layer shown in the following (Chemical Formula 3) of a hole transport material which was an arylamine compound was stacked, and subsequently the second light emitting unit was formed.

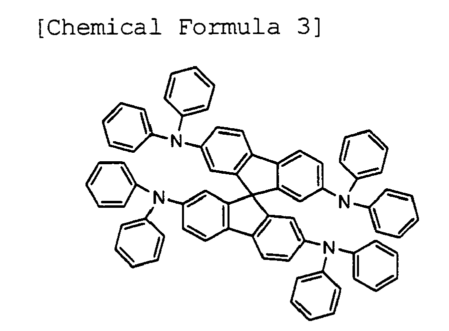

As for the cathode layer, while maintaining the vacuum chamber at a vacuum, masks were replaced to install masks for cathode vapor deposition. An aluminum (A1) layer was formed to have a film thickness of 100 nm.

The vacuum chamber was returned to ambient pressure, and the substrate on which each layer was deposited as described above was taken out, and it was moved in a glove box in which nitrogen substitution was carried out. By using a UV curing resin, it was sealed with another glass board to obtain a green phosphorescent EL element of a double-decked multi-photon structure.

### (Comparative Example 1)

As a reference 1, a usual-type green phosphorescence element which did not have the multi-photon structure was prepared in a procedure similar to that in Example 1 to have a layer structure as shown in Comparative Example 1 of Table 1.

### (Example 2)

A green phosphorescence element of the double-decked multi-photon structure was prepared in a procedure similar to that in Example 1 to have a layer structure as shown in Example 2 of Table 1.

The intermediate layer was arranged such that spiro-DPVBi and molybdenum trioxide were co-deposited to obtain a co-deposition layer and a layer of only spiro-DPVBi was formed between a spiro-TAD layer and the intermediate layer, to avoid direct contact between molybdenum trioxide and spiro-TAD which is an arylamine compound.

### (Comparative Example 2)

A green phosphorescence element of the double-decked multi-photon structure was prepared in a procedure similar to that in Example 1 to have a layer structure as shown in Comparative Example 2 of Table 1.

The intermediate layer was prepared in such a way that only spiro-TAD which is an arylamine compound was stacked and molybdenum trioxide was not co-deposited.

Each layer structure of the green phosphorescence element prepared in [Experiment 1] is shown in the following Table 1.

In addition, each numerical value in Table 1 shows a film thickness (nm) of each layer.

**[Table 1]**

| Film Thickness(nm) | Material (Dopant Concentration) | Comparative Example 1 (Reference 1) | Example 1 | Example 2 | Comparative Example 2 |
|---|---|---|---|---|---|
| Anode Layer | ITO | 110 | 110 | 110 | 110 |
| Hole Transport Layer | spiro-TAD: MoO₃(12%) | 61 | 61 | 61 | 61 |
| First Light Emitting Unit | CBP:Ir(ppy)₃(7%) | 20 | 20 | 20 | 20 |
| | BTPS | 10 | 10 | 10 | 10 |
| | DPB | 35 | 40 | 40 | 40 |
| | LiF | - | 0.5 | 0.5 | 0.5 |
| | Al | - | 1.5 | 1.5 | 1.5 |
| | DPB:Liq(26%) | 5 | - | - | - |
| Intermediate Layer | spiro-DPVBi: MoO₃(20%) | - | 61 | 51 | - |
| Second Light Emitting Unit | spiro-DPVBi | - | - | 10 | - |
| | spiro-TAD | - | 10 | 10 | 71 |
| | CBP: Ir(ppy)₃(7%) | - | 20 | 20 | 20 |
| | BTPS | - | 10 | 10 | 10 |
| | DPB | - | 40 | 40 | 40 |
| | LiF | - | 0.5 | 0.5 | 0.5 |
| Cathode Layer | Al | 100 | 100 | 100 | 100 |

FIG. 2 shows a graph of current efficiency / current density of each element in [Experiment 1].

As can be seen from the graph of FIG. 2, it was confirmed that the elements having the double-decked multi-photon structure in Examples 1 and 2 permitted substantially twice the current efficiency of the reference 1 (Comparative Example 1).

In the graph shown in FIG. 2, since the current efficiency of the elements of the double-decked multi-photon structure in Examples 1 and 2 exceed the twice, it is confirmed that both the elements function as a multi-photon element.

On the other hand, since the element of Comparative Example 2 permitted only the current efficiency substantially equal to that of the reference 1 (Comparative Example 1), it is assumed that luminescence for one unit only is obtained.

From the above result, although it is necessary for the molybdenum trioxide which is an electron accepting material to exist at the intermediate layer as requirements of operation for a multi-photon element. However, it was confirmed that mixture of or contact between the arylamine compound and molybdenum trioxide was not an essential requirement.

Further, as shown in Table 1, in the reference 1 (Comparative Example 1), Liq which was the metal complex and DPB which was an electron transport material were co-deposited to form the electron injection layer. Instead, in Examples 1 and 2, a LiF/Al layer was formed as the electron injection layer. In this case, it was also confirmed that it functioned as the multi-photon element. From this, it is assumed that existence of the electron donating material is not a requirement for constituting the intermediate layer, either.

### [Experiment 2] Confirmation of Formation of Charge-Transfer Complex

### (Example 3)

A simple substance film of spiro-DPVBi and a co-deposition film of it and MoO₃ were formed to have a thickness of 50 nm, and UV absorption spectra were measured.

These UV absorption spectra are shown in FIG. 3.

### (Example 4)

A simple substance film of spiro-6p and a co-deposition film of it and MoO₃ were formed to have a thickness of 50 nm, and UV absorption spectra were measured.

These UV absorption spectra are shown in FIG. 4.

### (Comparative Example 3)

A simple substance film of α-NPD and a co-deposition film of it and MoO₃ were formed to have a thickness of 50 nm, and UV absorption spectra were measured.

These UV absorption spectra are shown in FIG. 5.

### [Comparative Example 4]

As a control, a MoO₃ simple-substance film was formed to have a thickness of 20 nm, and a UV absorption spectrum was measured.

This UV absorption spectrum is shown in FIG. 6.

With respect to spiro-DPVBi (Example 3) shown in FIG. 3, the element in which molybdenum trioxide was co-deposited at a concentration of 20% by weight provided an absorption peak near a wavelength of 1500 nm. However, an absorption peak was not seen in the visible region. No absorption peaks were seen in the case where a concentration of molybdenum trioxide was reduced to 6% by weight.

With respect to spiro-6p (Example 4) shown in FIG. 4, fluctuation in spectrum was not confirmed regardless of whether there was molybdenum trioxide or not.

From the absorption spectrum of α-NPD (Comparative Example 3) as shown in FIG. 5, absorption peaks were confirmed near wavelengths of 500 nm and 1300 nm by co-depositing molybdenum trioxide. It is thought that the absorption peak near 500 nm originates from the formation of the charge-transfer complex.

As described above, improvement in luminous efficiency in the device which has a luminescence peak in an applicable wavelength band is expected by applying the non-arylamine compound to the intermediate layer of the element of multi-photon structure.

### [Experiment 3] Evaluation by Yellow Fluorescence Element (No. 1)

### (Comparative Example 5)

As a reference 2, a yellow fluorescence element of the double-decked multi-photon structure was prepared in a procedure similar to that in Example 1 to have a layer structure as shown in Comparative Example 5 of Table 2.

The intermediate layer was prepared in such a way that the lithium complex (Liq) was co-deposited with DPB which is the electron transport material, then aluminum (Al) was vapor-deposited on this layer, and further α-NPD that is an arylamine compound and molybdenum trioxide were co-deposited.

### (Example 5)

A yellow fluorescence element of the double-decked multi-photon structure was prepared in a procedure similar to that in Example 1 to have a layer structure as shown in Example 5 of Table 2.

In Example 5, Liq and Al of a DPB:Liq/Al layer function as the intermediate layer in the multi-photon element. However, this aluminum is very thin and does not form a thin film. It acts on Liq to activate Liq and functions as an electron donating material.

In addition, although two layers, the DPB:Liq/Al layer and the spiro-DPVBi: MoO₃ layer were formed as the intermediate layer in Example 5, the intermediate layer is not limited to a single layer but may be formed by stacking a plurality of layers in this way.

Each of the layer structures of the yellow fluorescence elements in Example 5 and Comparative Example 5 are shown in the following Table 2.

In addition, each numerical value in Table 3 shows a film thickness (nm) of each layer.

Further, TBADN is a compound shown below (Chemical Formula 4).

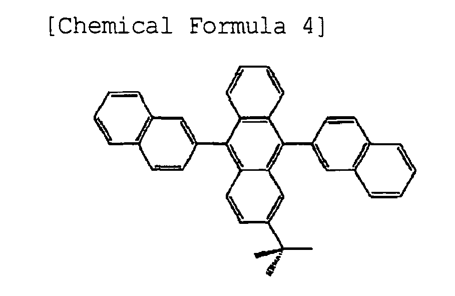

**[Table 2]**

| Film Thickness (nm) | Material (Dopant Concentration) | Comparative Example 5 (Reference 2) | Example 5 |
|---|---|---|---|
| Anode Layer | ITO | 300 | 300 |
| Hole Transport Layer | α-NPD: MoO₃(20%) | 25 | - |
| | α-NPD | 5 | - |
| | spiro-DPVBi: MoO₃(20%) | - | 55 |
| | spiro-DPVBi | - | 5 |
| First Light Emitting Unit | α-NPD: Rubrene(3%) | 10 | - |
| | spiro-DPVBi: Rubrene(3%) | - | 10 |
| | TBADN: Rubrene(3%) | 30 | 30 |
| | BAlq | 5 | 5 |
| Intermediate Layer | DPB:Liq(25%) | 45 | 45 |
| | Al | 1.5 | 1.5 |
| | α-NPD:MoO₃(20%) | 55 | - |
| | spiro-DPVBi: MoO₃(20%) | - | 55 |
| Second Light Emitting Unit | α-NPD | 5 | - |
| | spiro-DPVBi | - | 5 |
| | α-NPD: Rubrene(3%) | 10 | - |
| | spiro-DPVBi: Rubrene(3%) | - | 10 |
| | TBADN: Rubrene(3%) | 30 | 30 |
| | BALq | 5 | 5 |
| | DPB:Liq(25%) | 45 | 45 |
| Cathode Layer | Al | 100 | 100 |

### (Example 6)

In the intermediate layer, the concentration of the molybdenum trioxide to be co-deposited was changed from 20 % by weight to 6% by weight. Except for this, a yellow fluorescence element of the double-decked multi-photon structure was prepared similarly to Example 5.

### (Example 7)

Spiro-DPVBi for the intermediate layer and a layer in contact therewith was changed to spiro-6p. Further, the concentration of the molybdenum trioxide to be co-deposited was 13 % by weight. Except for these, a yellow fluorescence element of the double-decked multi-photon structure was prepared similarly to Example 5.

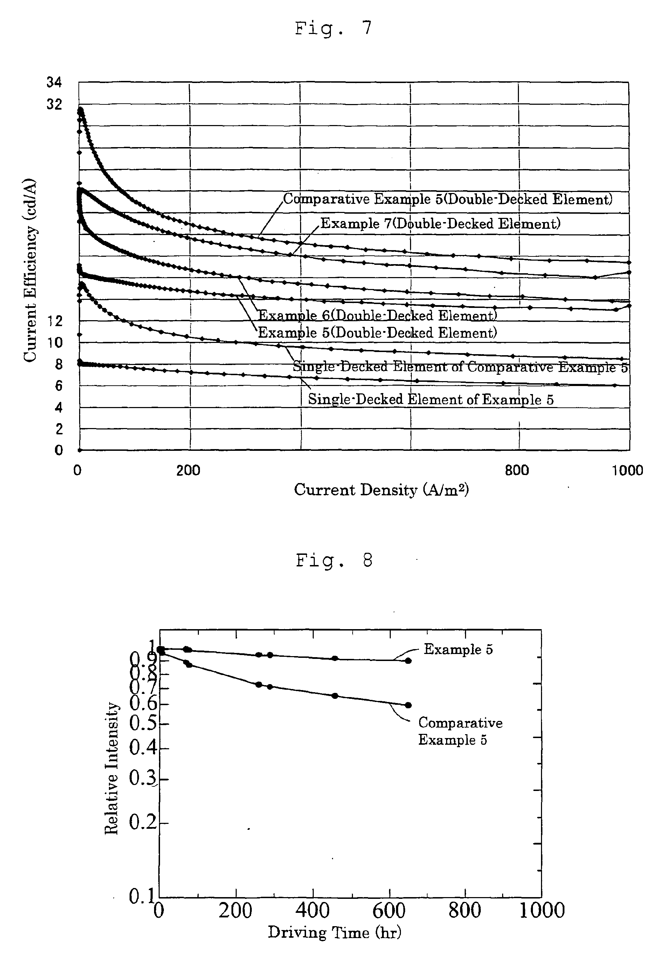

FIG. 7 shows a graph of current efficiency / current density of each element prepared in Experiment 3.

In addition, in the graph of FIG. 7, the data about a single-decked element corresponding to the elements of the double-decked multi-photon structure in Example 5 and Comparative Example 5 are also collectively shown for comparison.

As can be seen from the graph shown in FIG. 7, it was confirmed that the elements of the double-decked multi-photon structure in Example 5 and Comparative Example 5 had substantially twice the current efficiency of each of the single-decked elements.

Further, when the concentration of spiro-DPVBi was reduced (Example 6) and when spiro-6p was used (Example 7), it was also confirmed that the luminous efficiency equal to or greater than that in the case of Example 5 was obtained.

From this, it was confirmed that even one with the element structure which did not contain an arylamine compound at all functioned as the multi-photon element.

In addition, the reason why the current efficiency of Example 5 was smaller than that in Comparative Example 5 would be assumed that it was caused by the characteristics peculiar to the selected material.

Further, FIG. 8 shows, in graph, life characteristics of each element of Example 5 and Comparative Example 5 at a current density of 500 A/m².

As can be seen from the graph of FIG. 8, when driven at the same current density, it was confirmed that the element of Example 5 had a longer operation life than that of Comparative Example 5.

### [Experiment 4] Evaluation by Yellow Fluorescence Element (No. 2)

### (Example 8)

A yellow fluorescence element of the double-decked multi-photon structure was prepared in a procedure similar to that in Example 1 to have a layer structure as shown in Example 8 of Table 3.

In the intermediate layer, TBADN was used as the non-arylamine compound and molybdenum trioxide was used as a metal oxide of the electron accepting substance.

In the following Table 3, a layer structure of the yellow fluorescence element of Example 8 is shown together with that of Comparative Example 5 (reference 2).

In addition, each numerical value in Table 3 shows a film thickness (nm) of each layer.

**[Table 3]**

| Film Thickness(nm) | Material (Dopant Concentration) | Comparative Example 5 (Reference 2) | Example 8 |
|---|---|---|---|
| Anode Layer | ITO | 300 | 300 |
| Hole Transport Layer | α-NPD:MoO₃(20%) | 25 | 25 |
| | α-NPD | 5 | 5 |
| First Light Emitting Unit | α-NPD: Rubrene(3%) | 10 | 10 |
| | TBADN: Rubrene(3%) | 30 | 30 |
| | BAlq | 5 | 5 |
| | DPB | - | 45 |
| | LiF | - | 0.5 |
| | Al | - | 1.5 |
| Intermediate Layer | DPB:Liq(25%) | 45 | - |
| | Al | 1.5 | - |
| | α-NPD:MoO₃(20%) | 55 | - |
| | TBADN:MoO₃(20%) | - | 20 |
| Second Light Emitting Unit | TBADN | - | 5 |
| | α-NPD | 5 | 35 |
| | α-NPD: Rubrene(3%) | 10 | 10 |
| | TBADN: Rubrene(3%) | 30 | 30 |
| | BAlq | 5 | 5 |
| | DPB:Liq(25%) | 45 | 45 |
| | DPB | - | 45 |
| | LiF | - | 0.5 |
| Cathode Layer | Al | 100 | 100 |

### (Example 9)

TBADN for the intermediate layer and the layer in contact therewith was changed to a compound (DPPB) as shown below (Chemical Formula 5). Except for this, a yellow fluorescence element of the double-decked multi-photon structure was prepared similarly to Example 8.

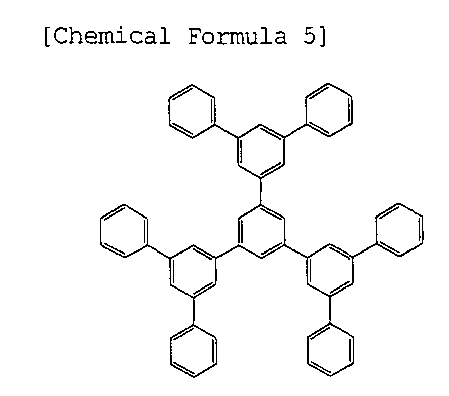

### (Example 10)

TBADN for the intermediate layer and the layer in contact therewith was changed to a compound (TMBN) as shown below (Chemical Formula 6). Except for this, a yellow fluorescence element of the double-decked multi-photon structure was prepared similarly to Example 8.

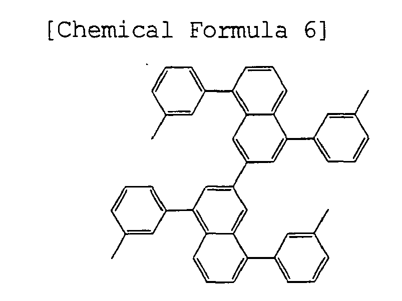

### (Example 11)

TBADN for the intermediate layer and the layer in contact therewith was changed to a compound (TPA) as shown below (Chemical Formula 7). Except for this, a yellow fluorescence element of the double-decked multi-photon structure was prepared similarly to Example 8.

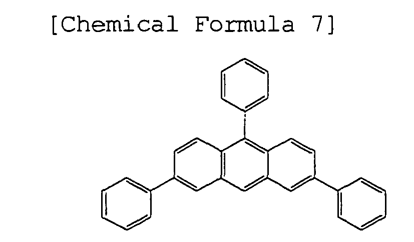

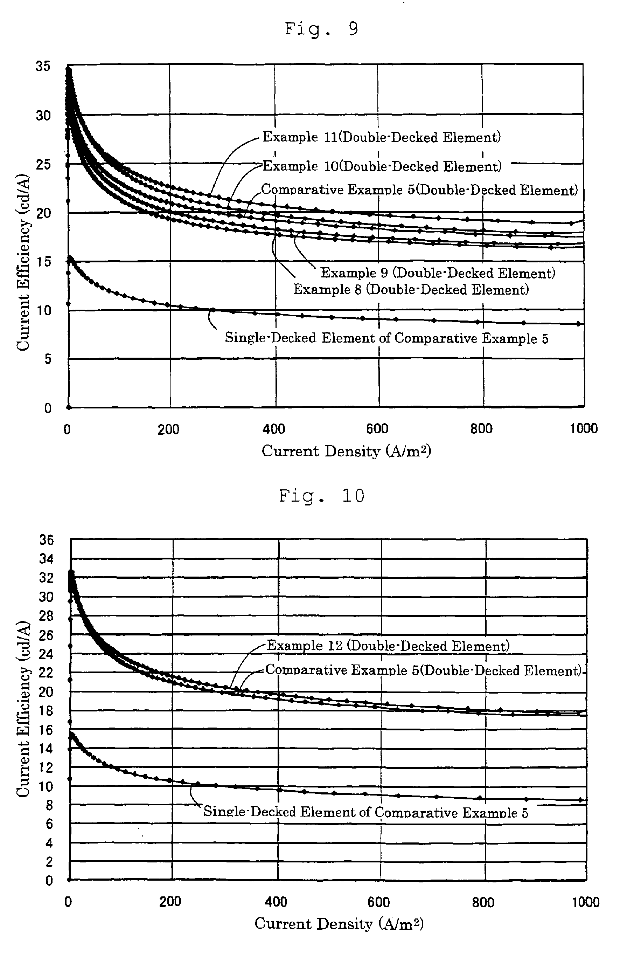

FIG. 9 shows a graph of current efficiency / current density of each element prepared in Experiment 4.

In addition, in the graph of FIG. 9, the data about the single-decked element corresponding to the elements of the double-decked multi-photon structure in Comparative Example 5 are also collectively shown for comparison.

As can be seen from the graph shown in FIG. 9, it was confirmed that the elements of the double-decked multi-photon structure in Examples 8-11 had substantially twice the current efficiency of the single-decked element of Comparative Example 5.

From this, it was confirmed that it functioned as the multi-photon element in the case of using DPPB, TMBN, or TPA as the non-arylamine compound and also in a layer structure where the DPB/Liq layer was replaced with a DPB/LiF layer in the intermediate layer.

In addition, the reason why the current efficiency of Examples 8 and 9 were smaller than that in Comparative Example 5 would be assumed that it was caused by the characteristics peculiar to the selected materials.

### [Experiment 5] Evaluation by Yellow Fluorescence Element (No. 3)

### (Example 12)

A yellow fluorescence element of the double-decked multi-photon structure was prepared in a procedure similar to that in Example 1 to have a layer structure as shown in Example 12 of Table 4.

In the intermediate layer, spiro-DPVBi was used as the non-arylamine compound, vanadium pentoxide was used as the metal oxide of the electron accepting material, and Liq was used as the electron donating material.

In the following Table 4, the layer structure of the yellow fluorescence element of Example 12 is shown together with that of Comparative Example 5 (reference 2).

In addition, each numerical value in Table 4 shows a film thickness (nm) of each layer.

**[Table 4]**

| Film Thickness(nm) | Material (Dopant Concentration) | Comparative Example 5 (Reference 2) | Example 12 |
|---|---|---|---|
| Anode Layer | ITO | 300 | 300 |
| Hole Transport Layer | α-NPD:MoO₃(20%) | 25 | - |
| | α-NPD:V₂O₅(20%) | - | 25 |
| | α-NPD | 5 | 5 |
| First Light Emitting Unit | α-NPD: Rubrene(3%) | 10 | 10 |
| | TBADN: Rubrene(3%) | 30 | 30 |
| | BAlq | 5 | 5 |
| | DPB | - | 30 |
| | spiro-DPVBi | - | 5 |
| Intermediate Layer | DPB:Liq(25%) | 45 | - |
| | spiro-DPVBi: Liq(50%) | - | 10 |
| | Al | 1.5 | 1.5 |
| | α-NPD:MoO₃(20%) | 55 | - |
| | spiro-DPVBi: V₂O₅ (20%) | - | 20 |
| Second Light Emitting Unit | spiro-DPVBi | - | 5 |
| | α-NPD | 5 | 35 |
| | α-NPD: Rubrene(3%) | 10 | 10 |
| | TBADN: Rubrene(3%) | 30 | 30 |
| | BAlq | 5 | 5 |
| | DPB | - | 40 |
| | DPB:Liq(25%) | 45 | 5 |
| Cathode Layer | Al | 100 | 100 |

FIG. 10 shows a graph of current efficiency / current density of each element prepared in Experiment 5.

In addition, in the graph of FIG. 10, the data about the single-decked element corresponding to the elements of the double-decked multi-photon structure in Comparative Example 5 are also collectively shown for comparison.

As can be seen from the graph shown in FIG. 10, it was confirmed that the elements of the double-decked multi-photon structure in Example 12 had substantially twice the current efficiency of the single-decked element of Comparative Example 5.

From this, it was confirmed that it functioned as the multi-photon element in the case where spiro-DPVBi was used as the non-arylamine compound, vanadium pentoxide was used as the metal oxide of the electron accepting material, and Liq and Al were used as the electron donating material in the intermediate layer.

### [Experiment 6] Confirmation of Formation of Charge-Transfer Complex

### (Example 13)

To have the layer structure of the intermediate layer of Example 12, i.e., a co-deposited layer of spiro-DPVBi and Liq with a thickness of 10 nm, an Al layer with a thickness of 1.5 nm, and a co-deposited layer of spiro-DPVBi and V₂O₅ with a thickness of 20 nm were stacked one by one, and its UV absorption spectrum was measured.

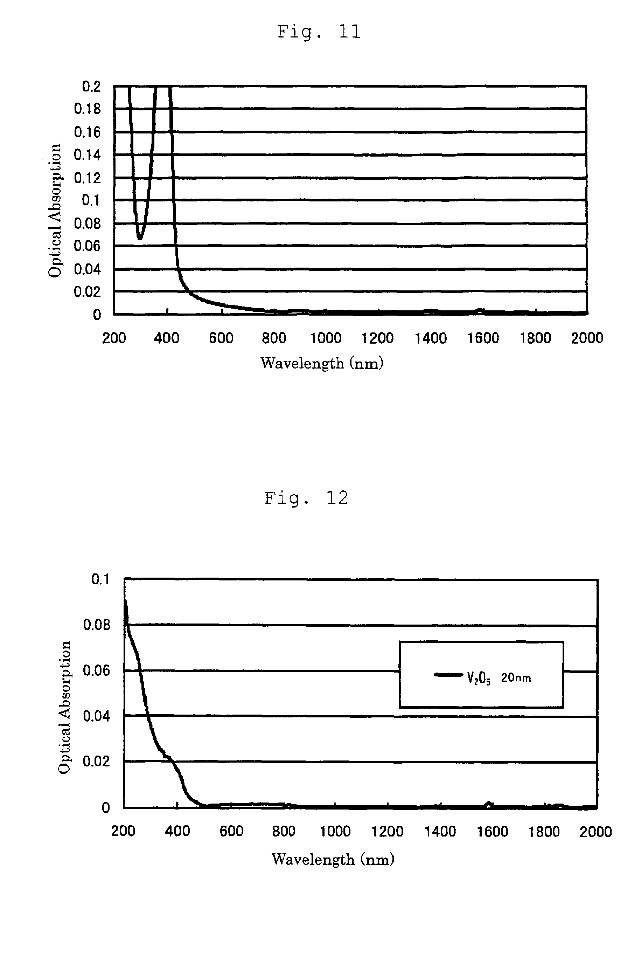

This UV absorption spectrum is shown in FIG. 11.

### (Comparative Example 6)

As a control, a V₂O₅ single layer film was formed to have a thickness of 20 nm, and a UV absorption spectrum was measured.

This UV absorption spectrum is shown in FIG. 12.

In the layer structure of the intermediate layer of Example 12 as shown in FIG. 11, although the spiro-DPVBi:Liq/Al layers were adjacent to the spiro-DPVBi: V₂O₅ layer, a particular absorption was not seen in the visible region. Thus, it was confirmed that the charge-transfer complex was not formed in this structure where the same material was used for the organic compounds to be mixed with or stacked on the electron accepting material and the electron donating material.

## Claims

1. An organic electroluminescent element formed on a substrate and having a multi-photon structure in which a plurality of light emitting units including at least one light emitting layer are stacked via an intermediate layer between an anode layer and a cathode layer which is a counter electrode, wherein
said intermediate layer is formed by mixing or stacking an electron accepting material or an electron donating material and an organic compound, so as to avoid formation of a charge-transfer complex.

2. The organic electroluminescence element as claimed in claim 1, wherein said intermediate layer is formed by mixing or stacking the electron accepting material and the organic compound, and its optical absorption coefficient in a 400-800 nm wavelength band is equal to or less than an optical absorption coefficient of said organic compound simple substance.

3. An organic electroluminescent element formed on a substrate and having a multi-photon structure in which a plurality of light emitting units including at least one light emitting layer are stacked via an intermediate layer between an anode layer and a cathode layer which is a counter electrode, wherein
said intermediate layer is formed of a layer in which an electron accepting material and an organic compound are mixed or stacked, and a layer in which an electron donating material and the same organic compound as said organic compound are mixed or stacked, to avoid formation of a charge-transfer complex.

4. The organic electroluminescence element as claimed in claim 1 or 3, wherein
said organic compound to be mixed with or stacked on the electron accepting material is a non-arylamine compound which does not contain, in its molecular structure, nitrogen atom having an electron donating property.

5. The organic electroluminescence element as claimed in claim 4, wherein said non-arylamine compound is a styryl compound or a polyarylene compound.

6. The organic electroluminescence element as claimed in claim 1 or 3, wherein
said electron accepting material is a metal oxide,

7. The organic electroluminescence element as claimed in claim 6, wherein
said metal oxide is any of a molybdenum oxide, a vanadium oxide, or a tungsten oxide.
